# EUROPEAN PATENT APPLICATION

(11) **EP 0 908 931 A2**
(43) Date of publication of application: **14.04.1999**
(21) Application number: 98203286.4
(22) Date of filing: 30.09.1998
(51) Int. Cl.: H01L 21/00

(54) **Conveying apparatus**

(30) Priority: 07.10.1997 JP 290460/97
(71) Applicant: Innotech Corporation, Yokohama-shi, Kanagawa-ken 222-8580 (JP)
(72) Inventor: Yoshida, Minoru, Yokohama-shi, Kanagawa-ken 222-8580 (JP); Doi, Takeshi, Yokohama-shi, Kanagawa-ken 222-8580 (JP)
(74) Representative: Vollebregt, Cornelis Jacobus, Ir.

(57) **Abstract**

A conveying apparatus suitable for use for an apparatus for manufacturing a semiconductor device is disclosed which is capable of being reduced in cost. The conveying apparatus includes a clean box (3), which is conveyed by a conveying structure. A conveying path (6) is provided so as to travelably arrange the conveying structure thereon. A clean bench (4) is arranged so as to be spaced from the conveying path (6) at a predetermined interval to define a space between the conveying path (6) and the clean bench (4) and constructed so as to eject clean air toward the conveying path (6) to keep the space between the conveying path (6) and the clean bench clean (4). Also, the clean bench (4) is provided on an end thereof extending in a direction of the conveying path with an air guide (5) in a manner to downwardly extend therefrom.

## Description

### BACKGROUND OF THE INVENTION

This invention relates to a conveying apparatus, and more particularly to a conveying apparatus adapted to convey a semiconductor device or the like.

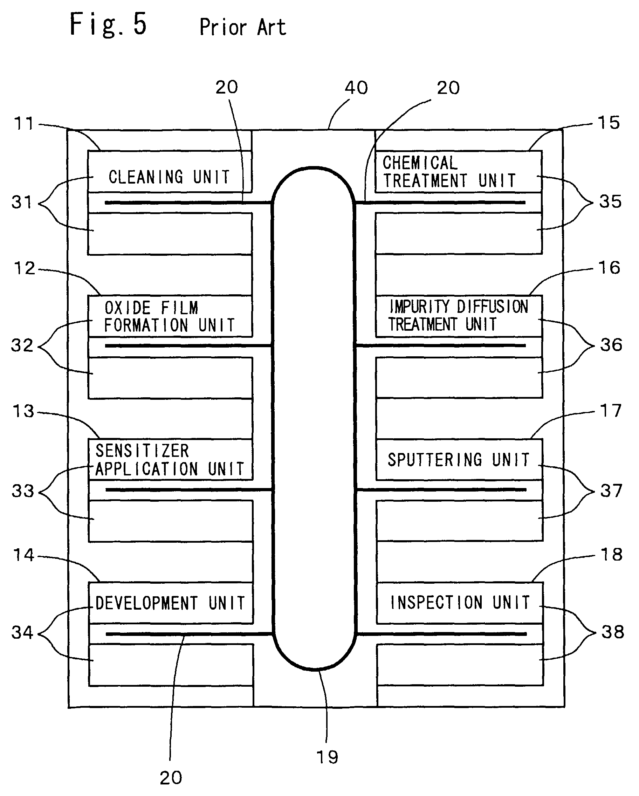

A conventional apparatus for manufacturing a semiconductor device is constructed in such a manner as shown in Fig. 5 by way of example. The apparatus is called a bay system and constituted of a plurality of step bays. The step bays each include a plurality of treating units of the same kind, which cooperate with each other to subject wafer substrates to the same treatment. Reference numerals 11 to 18 designate such step bays, respectively, which are arranged in a clean room 40.

Now, the step bays will be described hereinafter with reference to Fig. 5.

Reference numeral 11 designates a cleaning step bay, in which cleaning units 31 each are arranged so as to clean a surface of a wafer substrate.

Reference numeral 12 is an oxide film formation step bay which has oxide film formation units 32 arranged therein. The units 32 each are adapted to form an oxide film acting as a protective film on the surface of each of the wafer substrates cleaned in the cleaning step bay 11.

Then, the wafer substrates are carried or conveyed to a sensitizer application step bay 13, in which sensitizer application units 33 each are arranged so as to apply a sensitizer to the surface of each of the wafer substrates formed thereon with the oxide film.

Subsequently, the wafer substrates are conveyed to a development step bay 14 which has development units 34 set therein. In each of the development units 34, a mask depending on a pattern required is placed on the sensitizer applied to the surface of each of the wafer substrates to expose the sensitizer to light. Then, an unsensitized part of the sensitizer is removed from the surface of the wafer substrate. The step bays 13 and 14 cooperate with each other to carry out photo-processing.

Then, the wafer substrates are transferred to a chemical treatment step bay 15 having chemical treatment units 35 arranged therein, in each of which a treatment by means of chemicals is carried out on the surface of the wafer substrate to remove, from the surface of the wafer substrate, any unnecessary material such as a part of the oxide film remaining on the surface of the wafer substrate.

Reference numeral 16 designates an impurity diffusion step bay having impurity diffusion treatment units 36 provided therein. The impurity diffusion treatment units 36 each diffuse an impurity into the wafer substrate to form an impurity layer therein. Diffusion of an impurity is carried out by feeding impurity gas selected depending on an impurity layer to be formed into the unit.

Reference numeral 17 designates a sputtering step bay having sputtering units 37 set therein, wherein a thin film is formed on the surface of each of the wafer substrates having the impurity diffused thereinto by sputtering.

The wafer substrate thus manufactured is then subject to inspection in an inspection step bay 18 in which inspection units 38 are arranged.

The conventional semiconductor device manufacturing device also includes a monorail 19 for connecting the step bays 11 to 18 to each other in order. The monorail 19 is provided thereon with a carrier box (not shown) in a manner to be travelable thereon. The wafer substrates to be treated are conveyed to the step bays 11 to 18 in order while being carried on the carrier box.

The step bays 11 to 18 each are provided therein with a path 20 in a manner to be connected to the monorail 19. The path 20 is provided thereon with an automatic carrier mechanism for exclusive use in each of the steps bays in a manner to be travelable thereon. The automatic carrier mechanism acts to automatically unload the wafer substrates from the carrier box and carry them to the treating units in each of the step bays. Then, the automatic carrier mechanism returns the wafer substrates to the carrier box after the treatment in the treating units of the step bay.

The step bays, as described above, each are provided therein with a plurality of the identical treating units. Such arrangement of the identical treating units in each of the step bays permits a plurality of the wafer substrates to be concurrently treated.

The treatment steps respectively set in the step bays are combined together to manufacture a semiconductor device. The carrier box and the automatic carrier mechanism in each of the step bays respectively travel on the monorail 19 and the path 20 to carry the wafer substrates to the step bay for the treatment required.

In general, the number and order of steps required for manufacturing a semiconductor device are varied depending on a type of a semiconductor device to be manufactured. Thus, a CPU for control is used to select a path along which a wafer substrate is conveyed depending on a type of the semiconductor device.

In general, it is required to place a wafer substrate in an environment kept highly clean during manufacturing of a semiconductor device such as a transistor or the like. This is likewise true of the conventional semiconductor device manufacturing apparatus. Thus, the monorail 19 and path 20 as well as the treating units are required to be kept clean.

In order to meet the requirement, the prior art is so constructed that a whole room in which the treating units are arranged together with the monorail 19 and paths 20 is kept clean.

In order to permit the room to receive a number of such treating units, the monorail 19 extending over the step bays and the paths 20 arranged in the treating units therein, it is required to form the room into a huge space. Unfortunately, a large-scaled equipment and an increased cost are required to keep the room of such a huge space clean.

### SUMMARY OF THE INVENTION

The present invention has been made in view of the foregoing disadvantage of the prior art.

Accordingly, it is an object of the present invention to provide a conveying apparatus which is capable of being optimumly applied to an apparatus for manufacturing a semiconductor device.

It is another object of the present invention to provide a conveying apparatus which is capable of being manufactured with a reduced cost.

In accordance with the present invention, a conveying apparatus is provided. The conveying apparatus includes a clean box, a conveying means arranged so as to convey the clean box, a conveying path provided so as to travelably arrange the conveying means thereon, and a clean bench arranged so as to be upwardly spaced from the conveying path at a predetermined interval to define a space between the conveying path and the clean bench and constructed so as to eject clean air toward the conveying path to keep the space between the conveying path and the clean bench clean.

In a preferred embodiment of the present invention, the clean bench is provided on an end thereof extending in a direction of the conveying path with an air guide in a manner to downwardly extend therefrom.

In a preferred embodiment of the present invention, a closure means is arranged between the clean bench and the conveying path to close the space.

In a preferred embodiment of the present invention, exhaust ports are arranged below the space.

### BRIEF DESCRIPTION OF THE DRAWINGS

These and other objects and many of the attendant advantages of the present invention will be readily appreciated as the same becomes better understood by reference to the following detailed description when considered in connection with the accompanying drawings; wherein:
Fig. 1 is a schematic fragmentary perspective view showing an embodiment of a conveying apparatus according to the present invention;
Fig. 2 is a schematic fragmentary perspective view showing an apparatus for manufacturing a semiconductor device to which the conveyor apparatus shown in Fig. 1 is applied;
Fig. 3 is a schematic fragmentary perspective view showing another embodiment of a conveying apparatus according to the present invention;
Fig. 4 is a schematic fragmentary perspective view showing a further embodiment of a conveying apparatus according to the present invention; and
Fig. 5 is a schematic view showing a conventional apparatus for manufacturing a semiconductor device.

### DETAILED DESCRIPTION OF THE PREFERRED EMBODIMENTS

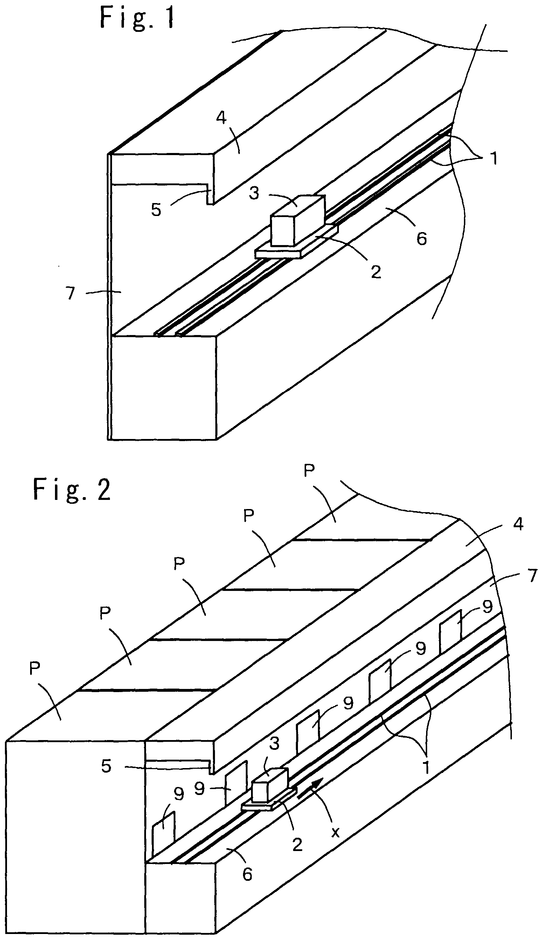

Now, a conveying apparatus according to the present invention will be described hereinafter with reference to Figs. 1 to 4, wherein like reference characters designate like or corresponding parts throughout.

Referring first to Fig. 1, a first embodiment of a conveying apparatus according to the present invention is illustrated. A conveying apparatus of the illustrated embodiment includes a conveying path 6 arranged for conveying a clean box 3 and a clean bench 4 arranged above the conveying path 6. The clean box 3 is constructed so as to receive wafer substrates therein for conveying. The clean box 3 is constructed into a closed structure, of which an interior is kept clean by means of a suitable unit (not shown).

The conveying apparatus of the illustrated embodiment also includes rails 1 provided on the conveying path 6 and arranged so as to permit a support base 2 to travel on the rails 1. The clean box 3 is placed on the support base 2. In the illustrated embodiment, the rails 1 and support base 2 cooperate with each other to constitute a conveying means.

The conveying path 6 is provided on one side thereof with a wall plate 7 in a manner to upwardly extend therefrom. The clean bench 4 is mounted on an upper end of the wall plate 7 in a manner to overhang the conveying path 6, resulting in a space being defined between the clean bench 7 and the conveying path 6. The clean bench 4 is constructed so as to downwardly eject clean air toward the conveying path 6, so that the space between the clean bench 4 and the conveying path 6 may be kept clean. The wall plate 7 acts as a closure member which prevents clean air from flowing out or escaping from a side of the wall plate 7.

The clean bench 4 is provided on an end thereof positioned opposite to the wall plate 7 and extending in a direction of the conveying path 6 with an air guide 5 downwardly extending from the end, so that the clean air may be downwardly guided or oriented by the air guide 5. Thus, the clean air downwardly directed by the air guide 5 acts as an air curtain which functions to prevent ambient air from entering the clean space between the clean bench 4 and the conveying path 6 and prevent the clean air from outwardly escaping from the clean space to an ambient atmosphere.

Thus, in the illustrated embodiment, the clean space constantly keeps the conveying path 6 clean, to thereby ensure that the clean box 3 traveling on the conveying path 6 is conveyed in a clean atmosphere.

The conveying apparatus of the illustrated embodiment thus constructed may be applied to a semiconductor device manufacturing apparatus in such a manner as shown in Fig. 2 by way of example. The manufacturing apparatus, as shown in Fig. 2, includes a plurality of step boxes P arranged on a side of the wall plate 7 in a manner to be spaced from each other in order. The step boxes P each are provided therein with treating units of the same type like those arranged in each of the step bays 11 to 18 of the prior art described above. The step boxes P are arranged in order of steps executed in manufacturing of the semiconductor device. The treating units of each step box P may be arranged in a lump. The step boxes P each are constructed so as to take the clean box on the conveying path 6 thereinto through each of gateways 9 formed at the wall plate 7. Also, the step boxes P each are provided therein with a wafer substrate carrier mechanism (not shown). The wafer substrate carrier mechanism functions to carry the clean box 33 taken into the step box P through the gateway 9 to each of treating units arranged in the step box P, to thereby permit each of wafer substrates received in the clean box P to be allocated to each of the treating units without being exposed to an ambient atmosphere.

The step boxes P each have an inner space defined therein, which is kept clean to substantially the same degree as the conveyor apparatus of the illustrated embodiment.

The clean box 3 supported on the support base 2 carried on the conveying path 6 have wafer substrates received therein. The clean box 3 is moved on the conveying path 6 in a direction indicated at an arrow X in Fig. 2, resulting in the wafer substrates being conveyed to each of the step boxes P. During such conveying, the clean box 3 is constantly kept clean, because the clean space is formed above the conveying path 6 as described above.

Now, the manner of operation of the semiconductor device manufacturing apparatus will be described hereinafter.

The clean box 3 carried on the conveying path 6 by means of the support base 2 is stopped at each of the gateways 9, resulting in being taken through the gateway into the step box P corresponding thereto. Then, in the step box P into which the clean box 3 is taken, the wafer substrates are subject to a predetermined treatment and then received in the clean box 3 again, followed by returning to the support base 2. The support base 2 on which the clean box is placed again is then transferred to the next step box P. Thus, the wafer substrates are carried to the subsequent step boxes P in order, to thereby be subject to predetermined treatments, leading to manufacturing of a semiconductor device desired.

In the semiconductor device manufacturing device shown in Fig. 2, as described above, the space above the conveying path 6 of the conveying apparatus is kept clean, so that wafer substrates may be conveyed on the conveying path 6 while being kept clean.

The conveying apparatus of the illustrated embodiment, as described above, is so constructed that the clean space is formed between the conveying path 6 and the clean bench 4, to thereby keep the conveying path clean, resulting in wafer substrates being conveyed while being kept clean.

The prior art, as described above, requires a clean room of a space increased to a degree sufficient to permit all treating units and the path to be received therein. The conveying apparatus of the first embodiment eliminates a necessity of such a clean room increased in space. In the illustrated embodiment, the clean bench is substituted for such a large-space clean room employed in the prior art, leading to a reduction in cost of equipment.

Referring now to Fig. 2, a second embodiment of a conveying apparatus according to the present invention is illustrated. A conveying apparatus of the second embodiment includes sliding doors 21 arranged between a clean bench 4 and a conveying path 6 so as to act as a closure means. The sliding doors 21 act to isolate a clean space defined between the clean bench 4 and the conveying path 6 from an ambient atmosphere, to thereby prevent clean air from escaping from the clean space to the ambient atmosphere and keep any foreign matter from intruding from the ambient atmosphere into the clean space. Such construction permits the space to be effectively kept clean while reducing the amount of clean air fed from the clean bench 4 to the space.

The sliding doors 21 each are formed at a lower portion thereof with a plurality of small holes 22 each acting as an exhaust port for clean air. Such arrangement of the exhaust port 22 at a lower section of the clean space permits clean air to flow toward the exhaust port, to thereby facilitate downward orientation of the clean air toward the conveying path 6.

Also, use of the sliding doors 21 as the closure means facilitates loading and unloading of a clean box 3 with respect to a support base 2, because it is merely required to open the sliding doors 21. Further, formation of transparent glass into the sliding doors 21 permits conveying of the clean box to be externally observed with a single glance.

The remaining part of the second embodiment may be constructed in substantially the same manner as the first embodiment described above.

Thus, it will be noted that the second embodiment likewise eliminates a necessity of arrangement of a clean room increased in space.

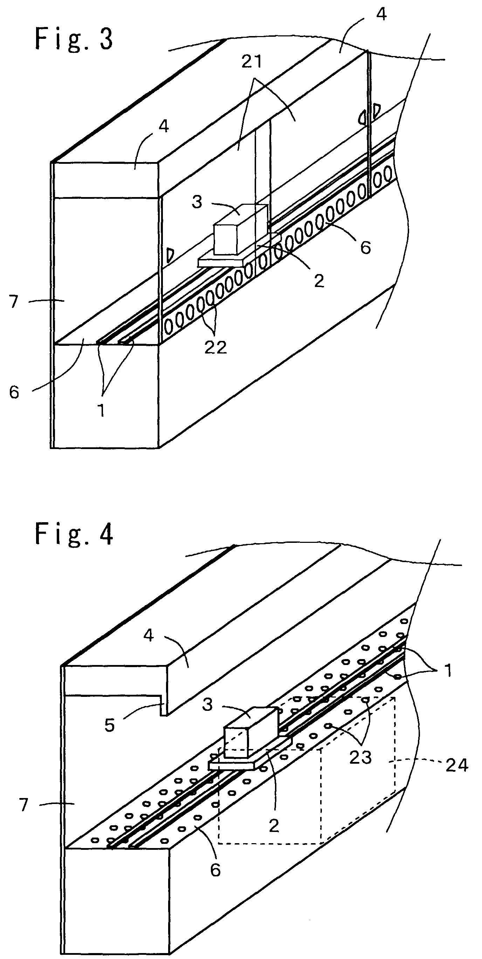

Referring now to Fig. 4, a third embodiment of a conveying apparatus according to the present invention is illustrated. In a conveying apparatus of the third embodiment, a conveying path 6 is defined by a punching board. The punching board is formed with a plurality of through-holes 23, each of which acts as an exhaust port for clean air. Also, the conveying apparatus of the illustrated embodiment includes an exhaust unit 24 arranged below the conveying path 6. The exhaust unit 24 functions to forcibly discharge clean air on the conveying path 6 via the through-holes 23 to a region below the conveying path 6.

Thus, in the third embodiment, the exhaust unit 24 is arranged below the through-holes 23 to forcibly exhaust clean air to an ambient atmosphere, so that flowing of clean air from the clean bench 4 may be more effectively downwardly directed while minimizing waste of clean air, resulting in the clean bench being significantly small-sized.

The remaining part of the third embodiment may be constructed in substantially the same manner as the first embodiment described above.

In the semiconductor device manufacturing apparatus of Fig. 2 which has the conveying apparatus of the first embodiment incorporated therein, the treating units are arranged in series in order of the steps executed. Alternatively, the apparatus of Fig. 2 may be applied to such arrangement of the treating units in the prior art as shown in Fig. 5. In this instance, the step boxes P are substituted for the step bays shown in Fig. 5 and the conveying apparatus of the present invention is substituted for the monorail 19. The steps boxes each are provided therein with one kind of treating unit and the conveying path of the conveying apparatus of the present invention is formed into an annular shape as in the monorail 19 of Fig. 5. The clean box in which the wafer substrates are received is caused to reciprocatedly travel on the conveying path in the clean space, to thereby carry the wafer substrate to the treating unit arranged in each of the step boxes.

Such arrangement eliminates a necessity of keeping a whole room of a large space clean, as well as a necessity of arranging an equipment increased in capacity to a degree sufficient to keep the large room clean.

Alternatively, the present invention may be constructed so that the treating units may be mounted directly on a rear side of the wall plate 7 of the conveying apparatus, rather than arrangement of the step boxes on the wall plate 7. In this instance, an intake port of each of the treating units through which the clean box 3 is taken into the treating unit is aligned with each of the gateways 9 of the wall plate 7.

The treating units each include a mechanism for carrying the wafer substrate from the clean box 3 to a treating section of the unit while keeping it clean. Also, the treating unit is constructed so as to keep an interior thereof clean by means of a mechanism peculiar thereto. Thus, direct mounting of the treating units on the wall plate 7 eliminates a necessity of keeping an exterior of the treating units clean.

Thus, arrangement of any clean room and such step boxes as described above may be eliminated.

As can be seen from the foregoing, the conveying apparatus of the present invention is so constructed that only the space above the conveying path is kept clean by means of the clean bench, to thereby eliminate a necessity of keeping the whole room clean as in the prior art. Such construction eliminates arrangement of an equipment of a large scale for keeping the whole room clean, leading to a reduction in cost of equipment.

Also, the present invention permits flowing of clean air to be directed to the conveying path while preventing escape of clean air to an outside of the clean space, to thereby ensure effective utilization of clean air. This results in the amount of clean air required being significantly decreased, leading to small-sizing of the clean box and a reduction in cost.

Further, the present invention may be constructed so that the closure means is arranged between the clean bench and the conveying path. This further reduces leakage or escape of clean air from the clean space.

In addition, arrangement of the exhaust ports below the clean space permits downward orientation of clean air in the clean space to be attained with increased efficiency.

While preferred embodiments of the invention have been described with a certain degree of particularity with reference to the drawings, obvious modifications and variations are possible in light of the above teachings. It is therefore to be understood that within the scope of the appended claims, the invention may be practiced otherwise than as specifically described.

## Claims

1. A conveying apparatus comprising:
a clean box (3);
a conveying means arranged so as to convey said clean box (3);
a conveying path (6) provided so as to travelably arrange said conveying means thereon; and
a clean bench (4) arranged so as to be upwardly spaced from said conveying path (6) at a predetermined interval to define a space between said conveying path (6) and said clean bench (4) and constructed so as to eject clean air toward said conveying path (6) to keep said space between said conveying path (6) and said clean bench clean (4).

2. A conveying apparatus as defined in claim 1, characterized in that said clean bench (4) is provided on an end thereof extending in a direction of said conveying path (6) with an air guide (5) in a manner to downwardly extend therefrom.

3. A conveying apparatus as defined in claim 1 or 2, characterized in that a closure means (21) is arranged between said clean bench (4) and said conveying path (6) to close said space.

4. A conveying apparatus as defined in any one of claims 1 to 3, characterized in that exhaust ports (22, 23) are arranged below said space.
